# EUROPÄISCHE PATENTSCHRIFT

(11) **EP 0 811 984 B1**
(45) Veröffentlichungstag und Bekanntmachung des Hinweises auf die Patenterteilung: **02.05.2001**
(21) Anmeldenummer: 96108955.4
(22) Anmeldetag: 04.06.1996
(51) Int. Cl.: G11C 11/406

(54) **Verfahren zum Lesen und Auffrischen eines dynamischen Halbleiterspeichers**
Method for reading and refreshing a dynamic semiconductor memory
Méthode de lecture et de rafraîchissement d'une mémoire dynamique à semi-conducteur

(43) Veröffentlichungstag der Anmeldung: 10.12.1997
(73) Patentinhaber: Infineon Technologies AG, 81669 München (DE)
(72) Erfinder: Zibert, Martin, Dipl.-Ing., 83052 Bruckmühl (DE)
(74) Vertreter: Zedlitz, Peter, Dipl.-Inf.

(56) Entgegenhaltungen:
- EP-A- 0 097 778
- EP-A- 0 170 285
- US-A- 4 691 303
- US-A- 5 488 581
- IEICE TRANSACTIONS ON ELECTRONICS, Bd. E79-C, Nr. 4, 1.April 1996, Seiten 472-481, XP000597417 KUMANOYA M ET AL: "TRENDS IN HIGH-SPEED DRAM ARCHITECTURES"

## Beschreibung

Die Erfindung bezieht sich auf ein Verfahren zum Lesen und Auffrischen von Dateninhalten eines dynamischen Halbleiterspeichers mit einer Vielzahl von in Spalten und Zeilen matrixförmig angeordneten flüchtigen Speicherzellen, wobei das Lesen von Dateninhalten aus adressierten Speicherzellen vermittels wenigstens zweier Datenbusse erfolgt, an denen die Dateninhalte wortweise angelegt werden, und das Auffrischen der Dateninhalte der Speicherzellen durch einen Refresh-Impuls erfolgt.

In dynamischen Halbleiterspeichern erfolgt die Speicherung von Information durch Anbringen und Entfernen von Ladungen auf einer jeder Speicherzelle zugeordneten Kapazität, die an einen über eine Wortleitung ansteuerbaren Auswahltransistor gekoppelt ist, über den die Kapazität ge- und entladen wird. Die Information von und zu der Speicherzelle fließt über eine gleichfalls mit dem Auswahltransistor verbundene Bitleitung. Beim Lesen wird die angesprochene Zelle auf die Bitleitung geschaltet, wodurch sich die Ladungsverhältnisse auf dieser Bitleitung ändern. Durch Aktivierung von Leseverstärkern wird die Ladungsänderung in der Bitleitung zur Ausgabe einer logischen Eins oder einer logischen Null verstärkt. Durch Leckströme verliert die Kapazität mit der Zeit bekanntlich ihre Ladung, so daß die Information der Speicherzelle in regelmäßigen Abständen aufgefrischt werden muß. Die zur Ansteuerung des dynamischen Halbleiterspeichers erforderlichen Signale und Signalkombinationen für die Funktionen Lesen, Schreiben und Auffrischen sind standardisiert. Ein solcher, dem erfindungsgemäßen Gegenstand zugrundeliegender Standard mit einem sehr effizienten Verfahren zum Lesen und gleichzeitigem Auffrischen von Dateninhalten stellt der sogenannte erweiterte Datenausgabemodus ("Enhanced Data Out") mit versteckter Auffrischung ("Hidden Refresh") nach der EDO-Spezifikation dar. Dieser erweiterte Datenausgabemodus ermöglicht einen schnellen Zugriff auf die Daten einer Zeile, da die Daten nicht wie bei den meisten anderen Datenausgabemodi mit einer Deaktivierung des Spaltenadressignales abgeschaltet werden. Die aktuell anstehenden Daten bleiben so bis zum Anlegen der nächsten Daten an den Ausgang aktiv. Dadurch stehen die Daten so lange wie möglich zur weiteren Verarbeitung, beispielsweise durch einen Prozessor, zur Verfügung. Die versteckte Auffrischung wurde eingeführt, um den Hardwareeinsatz zu verringern. Außerhalb des Halbleiterspeichers wird nur bestimmt, wann eine Auffrischung durchzuführen ist. Welches Datenwort aufgefrischt wird, wird innerhalb des Speichers bestimmt. Zu diesem Zweck ist ein interner Adresszähler vorgesehen, der mit jeder Auffrischungsanweisung um Eins hochgezählt wird und eine Zähleradresse ausgibt, die einer internen Logikschaltung als Zeilenadresse zugeführt wird. Zur Erkennung einer Auffrischungsanweisung wird ein Spaltenadressignal vor einem Zeilenadressignal aktiviert, damit einer am Adressbus anliegenden Adresse die Funktion einer Spaltenadresse bzw. Zeilenadresse zugewiesen werden kann. Während dieser Auffrischung bleibt das auszugebende Datenwort aktiv am Datenbus angelegt, und der Prozessor kann die Zeit zur Weiterverarbeitung des Datenwortes nutzen, während gleichzeitig Speicherzellen aufgefrischt werden. Bei einem dynamischen Halbleiterspeicher mit zwei oder mehreren Datenbussen ist nach dem Standard des erweiterten Datenausgabemodus (EDO-Standard) für jeden Datenbus ein Signaleingang zum Anlegen eines Spaltenadressignales vorgesehen. Während eines erweiterten Datenausgabemodus mit versteckter Auffrischung ist einerseits nur jenes Spaltenadressignal aktiv, an dessen zugeordnetem Datenbus als letztes ein Datenwort angelegt worden ist. Die versteckte Auffrischung wird durch eine zeitlich begrenzte Deaktivierung des Zeilenadressignales bei einem passiven Zustand wenigstens eines Spaltenadressignales eingeleitet, was andererseits eine Deaktivierung der Datenwörter an den den passiven Spaltenadressignalen zugeordneten Datenbussen bewirkt. Es bleibt somit lediglich das als letztes auf dem dem aktiven Spaltenadressignal zugeordneten Datenbus anliegende Datenwort aktiv und für den Prozessor verfügbar, während die übrigen Datenbusse bis zur Aktivierung der nächsten auszulesenden Datenwörter ungenutzt bleiben, und die abgeschalteten Datenwörter für beispielsweise einen Prozessor nicht mehr verfügbar sind.

Der Erfindung liegt die Aufgabe zugrunde, ein Verfahren zum Lesen und Auffrischen des Dateninhaltes eines dynamischen Halbleiterspeichers mit wenigstens zwei Datenbussen nach dem EDO-Standard zur Verfügung zu stellen, bei welchem durch die Auffrischungsanweisung keines der an den Datenbussen zum Lesen anliegenden Datenwörter abgeschaltet wird.

Diese Aufgabe wird durch ein Verfahren gemäß Anspruch 1 gelöst.

Erfindungsgemäß ist vorgesehen, daß die nach Auslösung des Refresh-Impulses an den Datenbussen anliegenden Datenwörter für eine vorbestimmte Zeitdauer an sämtlichen Datenbussen aufrechterhalten bleiben, und erst danach vermittels eines Abschaltimpulses abgeschaltet werden. Dies entspricht einer wirkungsvollen Änderung der Wahrheitstabelle der Schaltungslogik eines für den erweiterten Datenausgabemodus nach dem EDO-Standard spezifizierten dynamischen Halbleiterspeichers mit zwei oder mehreren Datenbussen, welche sich durch eine vergleichsweise geringe Änderung der internen Logik der Schaltung des entsprechend dem erweiterten Datenausgabemodus (EDO) spezifizierten Halbleiterspeichers umsetzen läßt. Gegenüber dem erweiterten Datenausgabemodus (EDO) mit versteckter Auffrischung ("Hidden Refresh") besitzt die Erfindung den Vorteil, daß sämtliche zum Zeitpunkt der Auffrischungsanweisung an den Datenbussen zum Lesen anliegenden Datenwörter auch während der Auffrischung an den Datenbussen anliegen, und erst durch den Abschaltimpuls abgeschaltet werden. Dadurch werden während der Auffrischung dem Prozessor an jedem Datenbus jeweils ein Datenwort zur Weiterverarbeitung zur Verfügung gestellt, ohne die weiteren effektiven Möglichkeiten des EDO-Standards einzuschränken.

Dem Prinzip der Erfindung folgend kann vorgesehen sein, daß durch einen Übergang eines Zeilenadressignales in den aktiven Zustand der an einem Adressbus anliegenden Adresse eine Zeilenadresse zugeordnet wird, durch einen Übergang eines Spaltenadressignales in den aktiven Zustand der am Adressbus anliegenden Adresse eine Spaltenadresse zugeordnet wird, ein kurzzeitiger aktiver Zustand des Zeilenadressignales bei einem gleichzeitig passiven Zustand wenigstens eines Spaltenadressignales dem Refresh-Signal entspricht, und durch den Übergang des Zeilenadressignales in den passiven Zustand bei einem gleichzeitig passiven Zustand der beiden Spaltenadresssignale alle an den Datenbussen anliegenden Datenwörter abgeschaltet werden. Dies bewirkt, daß innerhalb eines durch ein aktives Lesesignal eingeschalteten Lesezustandes ein Datenwort an einem Datenbus solange anliegt, bis ein weiteres Datenwort aus den Speicherzellen an dem selben Datenbus angelegt wird. Dadurch stehen die an den Datenbussen anliegenden Datenwörter dem Prozessor für eine maximal mögliche Zeitdauer zur Verfügung. Dadurch, daß der Abschaltimpuls aus einem Übergang des Zeilenadressignales in den passiven Zustand bei gleichzeitig passiven Zuständen aller Spaltenadressignale besteht, wird durch den Refresh-Impuls, welcher seinerseits aus einem zeitlich begrenzten Zustand des Zeilenadressignales während eines passiven Zustandes wenigstens eines Spaltenadressignales besteht, kein an den Datenbussen anliegendes Datenwort abgeschaltet. Erst bei einem Übergang des Zeilenadressignales in den passiven Zustand, wobei sich gleichzeitig sämtliche Spaltenadressignale im passiven Zustand befinden, werden die an den Datenbussen anliegenden Datenwörter abgeschaltet. Bei einem gemäß der Erfindung aufgebauten dynamischen Halbleiterspeicher werden auch in einem Lesezustand ohne versteckte Auffrischung die an den Datenbussen anliegenden Datenwörter erst bei gleichzeitig passiven Zeilenadress- und Spaltenadressignalen abgeschaltet, wodurch aber kein Nachteil entsteht, da die mit einem Übergang des Lesesignales in den passiven Zustand oder einem Übergang des Schreibsignales in den aktiven Zustand einhergehenden weiteren Abschaltmöglichkeiten der an den Datenbussen anliegenden Datenwörter unberührt bleiben.

Für das Anlegen eines auszulesenden Datenwortes an einen Datenbus kann vorgesehen sein, daß nach dem Übergang des Zeilenadressignales, eines Lesesignales und des Spaltenadressignales in den aktiven Zustand das in den adressierten Speicherzellen abgelegte Datenwort an den dem Spaltenadressignal im aktiven Zustand zugeordneten Datenbus angelegt wird.

Um die Anlegedauer auszulesender Datenwörter zu maximieren kann weiterhin von Vorteil vorgesehen sein, daß bei einem aktiven Zustand des Zeilenadressignales und des Lesesignales und einem passiven Zustand des Spaltenadressignales und des Schreibsignales des an dem dem Spaltenadressignal im passiven Zustand zugeordneten Datenbus anliegende Datenwort aufrechterhalten bleibt. Um ein auszulesendes Datenwort an einen Datenbus anzulegen, ist es nach der EDO-Spezifikation erforderlich, daß die allen anderen Datenbussen zugeordneten Spaltenadressignale sich im passiven Zustand befinden. Dadurch, daß durch den Übergang des Spaltenadressignales das entsprechende Datenwort weiterhin angelegt bleibt, kann der zeitliche Abstand zwischen dem Anlegen zweier Datenwörter gering gehalten werden.

Um anderen an die Datenbusse gekoppelten Schaltungen eine sichere Ausgabe von Datenwörtern zu ermöglichen, kann vorgesehen sein, daß ein Tristate-Zustand an allen Datenbussen bei einem passiven Zustand des Zeilenadressignales und aller Spaltenadressignale eingeschaltet wird.

Als weitere Maßnahme zur Ansteuerung des Halbleiterspeichers für die Ausgabe von Daten kann von Vorteil vorgesehen sein, daß bei einem aktiven Zustand der Zeilenadressignale und Spaltenadressignale und einem passiven Zustand des Schreibsignales durch das Setzen des Lesesignales in den aktiven Zustand der Halbleiterspeicher in einen Lesezustand versetzt wird.

Im Sinne einer eindeutigen Festlegung des Lesezustandes oder des Schreibzustandes kann von Vorteil vorgesehen sein, daß bei einem aktiven Zustand des Zeilenadressignales, der Spaltenadressignale und der Lesesignales der Übergang des Schreibsignales in den aktiven Zustand gesperrt wird.

Bei einer bevorzugten Ausführung kann vorgesehen sein, daß den aktiven Zuständen die logische Null, und den passiven Zuständen der binären Steuersignale die logische Eins entspricht.

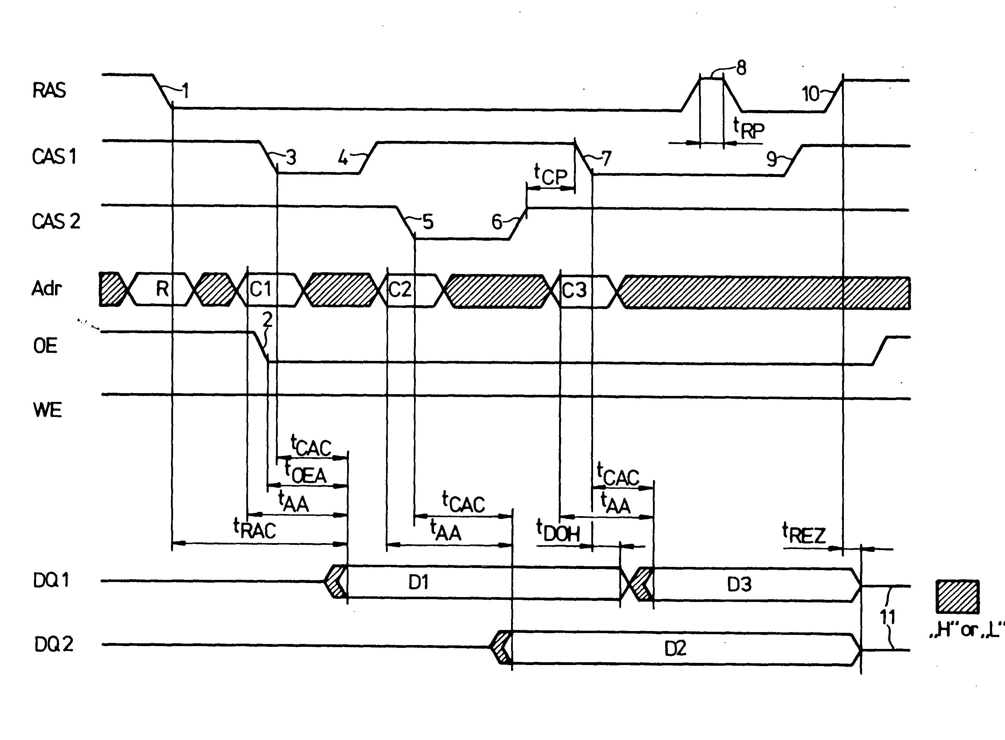

Weitere Merkmale, Vorteile und Zweckmäßigkeiten der Erfindung ergeben sich aus der nachfolgenden Beschreibung eines Ausführungsbeispieles anhand der einzigen Figur.

Die Figur zeigt die zeitlichen Verläufe eines Zeilenadresssignales RAS ("Row Access Strobe"), jeweils den beiden Datenbussen DQ1 und DQ2 zugeordneten Spaltenadressignale CAS1 bzw. CAS2 ("Column Access Strobe"), eines Lesesignales OE ("Output Enable") und eines Schreibsignales WE ("Write Enable"), sowie der an einem Adressbus Adr anliegenden Zeilenadresse R und Spaltenadressen C1, C2, C3, und an den beiden Datenbussen DQ1, DQ2 anliegenden Datenwörter D1, D2, D3 während eines Lesezustandes mit versteckter Auffrischung bei einem dynamischen Halbleiterspeicher. Die Ansteuerung des dynamischen Halbleiterspeichers durch das Zeilenadressignal RAS, das dem ersten Datenbus DQ1 zugeordnete erste Spaltenadressignal CAS1, das dem zweiten Datenbus DQ2 zugeordnete zweite Spaltenadresssignal CAS1, das Lesesignal OE und das Schreibsignal WE nach dem EDO-Standard mit getakteten Impulsen ist dem Fachmann geläufig und braucht an dieser Stelle nicht in allen Einzelheiten erläutert zu werden. Auf die JEDEC-Spezifikation für DRAMs, Extended Data Output (EDO), wird hiermit verwiesen und vollinhaltlich Bezug genommen.

Die Steuersignale befinden sich anfangs im passiven Zustand, d.h. auf einer logischen Eins bzw. auf dem höheren Spannungspegel von etwa + 5 V. Durch einen Übergang 1 des Zeilenadressignales RAS in den aktiven Zustand wird der am Adressbus Adr anliegenden ersten Adresse die Funktion einer Zeilenadresse R zugeordnet. Die Aktivierung 2 des Lesesignales OE versetzt den Halbleiterspeicher in den Lesezustand und ermöglicht die Ausgabe von Daten aus den Speicherzellen. Die kurz darauf erfolgende Aktivierung 3 des ersten Spaltenadressignales CAS1 ordnet der am Adressbus Adr anliegenden zweiten Adresse die Funktion einer ersten Spaltenadresse C1 zu. Die erste Zeilenadresse R und die erste Spaltenadresse C1 sind einer Gruppe von Speicherzellen zugeordnet und legen das in der Gruppe von Speicherzellen abgelegte Datenwort D1 fest, das aktivierte erste Spaltenadressignal CAS1 legt den dem ersten Spaltenadressignal CAS1 zugeordneten Datenbus DQ1 fest, und das Lesesignal OE im aktiven Zustand legt fest, daß sich der Halbleiterspeicher im Lesezustand befindet. Damit wird das der ersten Zeilenadresse R und ersten Spaltenadresse C1 zugeordnete erste Datenwort D1 am ersten Datenbus DQ1 angelegt. Nach einer Deaktivierung 4 des ersten Spaltenadressignales CAS1 bleibt das erste Datenwort D1 am ersten Datenbus DQ1 aktiv. Es steht also weiterhin anderen Schaltungsteilen, beispielsweise einem mit dem Halbleiterspeicher in Verbindung stehenden Prozessor zur Verfügung. Durch die Aktivierung 5 des zweiten Spaltenadressignales CAS2 wird der am Adressbus Adr anliegenden dritten Adresse die Funktion einer zweiten Spaltenadresse C2 zugeordnet, und das der Zeilenadresse R und der zweiten Spaltenadresse C2 zugeordnete zweite Datenwort D2 am zweiten Datenbus DQ2 angelegt. Nach der Deaktivierung 6 des zweiten Spaltenadressignales CAS2 bleibt das zweite Datenwort D2 am zweiten Datenbus DQ2 aktiv und kann somit ebenso weiterhin vom Prozessor gelesen werden. Nach einer weiteren Aktivierung 7 des ersten Spaltenadressignales CAS1 wird der am Adressbus Adr anliegenden vierten Adresse die Funktion einer dritten Spaltenadresse C3 zugeordnet, und das der Zeilenadresse R und dritten Spaltenadresse C3 zugeordnete dritte Datenwort D3 am ersten Datenbus DQ1 angelegt, wobei das erste Datenwort D1 bis unmittelbar vor dem Anlegen des dritten Datenwortes D3 aktiv bleibt. Insoweit entspricht die dargestellte Implementierung der an den Datenbussen DQ1, DQ2 anliegenden Datenwörter D1, D2, D3 aufgrund der Zustände der Steuersignale RAS, CAS1, CAS2, OE, WE dem standardisierten erweiterten Datenausgabemodus (EDO), wobei die in der Figur bezeichneten Zeitabschnitte folgendes bedeuten:
- t_{RAC}: maximale Zugriffszeit nach dem Zeilenadressignal
- t_{AA}: maximale Zugriffszeit nach der Spaltenadresse
- t_{OEA}: maximale Zugriffszeit nach dem Lesesignal
- t_{CAC}: maximale Zugriffszeit nach dem Spaltenadressignal
- t_{CP}: Mindestzeit zwischen zwei Spaltenadressignal
- t_{DOH}: Mindesthaltezeit des vorherigen CAS-Zugriffs
- t_{RP}: zeitliche Dauer der Auffrischungsanweisung
- t_{REZ}: maximale Abschaltzeit des Datenausganges, bezogen auf das Abschalten des Zeilenadressignales.

Bei den in der Figur schraffiert dargestellten Signalen des Adressbusses Adr und der Datenbusse DQ1, DQ2 liegt an allen Bitleitungen entweder die logische Eins oder die logische Null an. Bei den in der Figur durch eine waagrechte Linie dargestellten Signalen der Datenbusse DQ1, DQ2 befindet sich der jeweilige Datenbus DQ1 bzw. DQ2 in einem Tristate-Zustand.

Erfindungsgemäß ist vorgesehen, daß durch eine über den Zeitraum t_{RP} begrenzte Deaktivierung 8 des Zeilenadressignales RAS eine Auffrischung der Speicherzellen angeordnet wird. Hierbei wird bei einer Deaktivierung 8 des Zeilenadressignales RAS, während das zweite Spaltenadressignal CAS2 sich im passiven Zustand befindet, mindestens eines der Spaltenadressignale CAS1 aktiv geschaltet. Nach erneuter Deaktivierung 9 des ersten Spaltenadressignales CAS1 bleiben das zweite Datenwort D2 am zweiten Datenbus DQ2 und das dritte Datenwort D3 am ersten Datenbus DQ1 weiterhin aktiv und für den Prozessor verfügbar. Erst durch die Deaktivierung 10 des Zeilenadressignales RAS werden beide Datenwörter D2, D3 abgeschaltet und die Datenbusse DQ1, DQ2 in den Tristate-Zustand 11 gesetzt. Auch bei einem Lesen ohne Auffrischung würden die an den Datenbussen DQ1, DQ2 anliegenden auszulesenden Datenwörter D2, D3 erst abgeschaltet werden, wenn sich das Zeilenadressignal RAS und die beiden Spaltenadressignale CAS1, CAS2 im passiven Zustand befinden, wodurch die EDO-Spezifikation nicht eingeschränkt wird und keine Nachteile entstehen, da mit einem Übergang des Lesesignales (OE) in den passiven Zustand, oder mit einem Übergang des Schreibsignales (WE) in den aktiven Zustand weitere Abschaltmöglichkeiten bestehen.

### Bezugszeichenliste

- 1: Übergang des Zeilenadressignales in den aktiven Zustand
- 2: Übergang des Lesesignales in den aktiven Zustand
- 3: Übergang des ersten Spaltenadresssignales in den aktiven Zustand
- 4: Übergang des ersten Spaltenadressignales in den passiven Zustand
- 5: Übergang des zweiten Spaltenadressignales in den aktiven Zustand
- 6: Übergang des zweiten Spaltenadressignales in den passiven Zustand
- 7: Übergang des ersten Spaltenadressignales in den aktiven Zustand
- 8: zeitlich begrenzter Übergang des Zeilenadressignales in den passiven Zustand
- 9: Übergang des ersten Spaltenadressignales in den passiven Zustand
- 10: Übergang des Zeilenadressignales in den passiven Zustand
- 11: Tristate-Zustand
- RAS: Zeilenadressignal
- CAS1: erstes Spaltenadressignal
- CAS2: zweites Spaltenadressignal
- OE: Lesesignal
- WE: Schreibsignal
- Adr: Adressbus
- DQ1: erster Datenbus
- DQ2: zweiter Datenbus
- R: Reihenadresse
- C1: erste Spaltenadresse
- C2: zweite Spaltenadresse
- C3: dritte Spaltenadresse
- D1: erstes zu lesendes Datenwort
- D2: zweites zu lesendes Datenwort
- D3: drittes zu lesendes Datenwort
- t_{RAC}: maximale Zugriffszeit nach dem Zeilenadressignal
- t_{AA}: maximale Zugriffszeit nach der Spaltenadresse
- t_{OEA}: maximale Zugriffszeit nach dem Lesesignal
- t_{CAC}: maximale Zugriffszeit nach dem Spaltenadressignal
- t_{CP}: Mindestzeit zwischen zwei Spaltenadressignal
- t_{DOH}: Mindesthaltezeit des vorherigen CAS-Zugriffs
- t_{RP}: zeitliche Dauer der Auffrischungsanweisung
- t_{REZ}: maximale Abschaltzeit des Datenausganges, bezogen auf das Abschalten des Zeilenadressignales

## Patentansprüche

1. Verfahren zum Lesen und Auffrischen von Dateninhalten eines dynamischen Halbleiterspeichers mit einer Vielzahl von in Spalten und Zeilen matrixförmig angeordneten flüchtigen Speicherzellen, wobei das Lesen von Dateninhalten aus adressierten Speicherzellen vermittels wenigstens zweier Datenbusse (DQ1, DQ2) erfolgt, an denen die Dateninhalte wortweise angelegt werden, und das Auffrischen der Dateninhalte der Speicherzellen durch einen Refresh-Impuls erfolgt,
dadurch gekennzeichnet, daß
die nach Auslösung des Refresh-Impulses an den Datenbussen (DQ1, DQ2) anliegenden Datenwörter (D1, D3) für eine vorbestimmte Zeitdauer an sämtlichen Datenbussen aufrechterhalten bleiben und erst danach vermittels eines Abschaltimpulses abgeschaltet werden.

2. Verfahren nach Anspruch 1, dadurch gekennzeichnet, daß durch einen Übergang (1) eines Zeilenadressignales (RAS) in den aktiven Zustand der an einem Adressbus (Adr) anliegenden Adresse eine Zeilenadresse (R) zugeordnet wird, durch einen Übergang (3, 5, 7) eines Spaltenadressignales (CAS1, CAS2) in den aktiven Zustand der am Adressbus (Adr) anliegenden Adresse eine Spaltenadresse (C1, C2, C3) zugeordnet wird, ein kurzzeitiger (t_{RF}) passiver Zustand (8) des Zeilenadressignales (RAS) bei einem gleichzeitig passiven Zustand wenigstens eines Spaltenadressignales (CAS1, CAS2) dem Refresh-Signal entspricht, und durch den Übergang (10) des Zeilenadressignales (RAS) in den passiven Zustand bei einem gleichzeitig passiven Zustand der beiden Spaltenadressignale (CAS1, CAS2) alle an den Datenbussen (DQ1, DQ2) anliegenden Datenwörter (D1, D2, D3) abgeschaltet werden.

3. Verfahren nach einem der Ansprüche 1 bis 2, dadurch gekennzeichnet, daß nach dein Übergang (1) des Zeilenadressignales (RAS), (2) eines Lesesignales (OE) und (3) des Spaltenadressignales (CAS1, CAS2) in den aktiven Zustand das in den adressierten Speicherzellen abgelegte Datenwort (D1, D2, D3) an den dem Spaltenadressignal (CAS1, CAS2) im aktiven Zustand zugeordneten Datenbus (DQ1, DQ2) angelegt wird.

4. Verfahren nach einem der Ansprüche 1 bis 3, dadurch gekennzeichnet, daß bei einem aktiven Zustand des Zeilenadresssignales (RAS) und des Lesesignales (OE) und einem passiven Zustand des Spaltenadressignales (CAS1, CAS2) und des Schreibsignales (WE) die an dem dem Spaltenadressignal (CAS1, CAS2) im passiven Zustand Datenbussen (DQ1, DQ2) anliegenden Datenwörter (D1, D2, D3) aufrechterhalten bleiben.

5. Verfahren nach einem der Ansprüche 1 bis 4, dadurch gekennzeichnet, daß an allen Datenbussen (DQ1, DQ2) bei einem passiven Zustand des Zeilenadressignales (RAS) und aller Spaltenadressignale (CAS1, CAS2) ein Tristate-Zustand (11) eingeschaltet wird.

6. Verfahren nach einem der Ansprüche 1 bis 5, dadurch gekennzeichnet, daß bei einem aktiven Zustand der Zeilenadresssignale (RAS) und Spaltenadressignale (CAS1, CAS2) und einem passiven Zustand des Schreibsignales (WE) durch das Setzen des Lesesignales (OE) in den aktiven Zustand der Halbleiterspeicher in einen Lesezustand versetzt wird.

7. Verfahren nach einem der Ansprüche 1 bis 6, dadurch gekennzeichnet, daß bei einem aktiven Zustand des Zeilenadresssignales (RAS), der Spaltenadressignale (CAS1, CAS2) und der Lesesignales (OE) der Übergang des Schreibsignales (WE) in den aktiven Zustand gesperrt wird.

8. Verfahren nach einem der Ansprüche 1 bis 7, dadurch gekennzeichnet, daß den aktiven Zuständen die logische Null und den passiven Zuständen die logische Eins entspricht.

## Claims

1. Method for reading and refreshing data contents of a dynamic semiconductor memory having a multiplicity of volatile memory cells arranged in matrix form in columns and rows, data contents being read from addressed memory cells by means of at least two data buses (DQ1, DQ2) to which the data contents are applied word by word, and the data contents of the memory cells being refreshed by means of a refresh pulse,
characterized in that
the data words (D1, D3) present on the data buses (DQ1, DQ2) after the triggering of the refresh pulse are maintained on all the data buses for a predetermined period of time and only afterwards are switched off by means of a switch-off pulse.

2. Method according to Claim 1, characterized in that a row address (R) is assigned to the address present on an address bus (Adr) as a result of a transition (1) of a row address signal (RAS) into the active state, a column address (C1, C2, C3) is assigned to the address present on the address bus (Adr) as a result of a transition (3, 5, 7) of a column address signal (CAS1, CAS2) into the active state, a momentary (t_{RF}) passive state (8) of the row address signal (RAS) in conjunction with a simultaneously passive state of at least one column address signal (CAS1, CAS2) corresponds to the refresh signal, and all the data words (D1, D2, D3) present on the data buses (DQ1, DQ2) are switched off as a result of the transition (10) of the row address signal (RAS) into the passive state in conjunction with a simultaneously passive state of the two column address signals (CAS1, CAS2).

3. Method according to either of Claims 1 and 2, characterized in that, after the transition (1) of the row address signal (RAS), (2) of a read signal (OE) and (3) of the column address signal (CAS1, CAS2) into the active state, the data word (D1, D2, D3) stored in the addressed memory cells is applied to the data bus (DQ1, DQ2) assigned to the column address signal (CAS1, CAS2) in the active state.

4. Method according to one of Claims 1 to 3, characterized in that, in the case of an active state of the row address signal (RAS) and of the read signal (OE) and a passive state of the column address signal (CAS1, CAS2) and of the write signal (WE), the data words (D1, D2, D3) present on the data buses (DQ1, DQ2) assigned to the column address signal (CAS1, CAS2) in the passive state are maintained.

5. Method according to one of Claims 1 to 4, characterized in that a tristate state (11) is switched on on all the data buses (DQ1, DQ2) in the case of a passive state of the row address signal (RAS) and of all the column address signals (CAS1, CAS2).

6. Method according to one of Claims 1 to 5, characterized in that, in the case of an active state of the row address signals (RAS) and column address signals (CAS1, CAS2) and a passive state of the write signal (WE), the semiconductor memory is put into a read state as a result of the read signal (OE) being set to the active state.

7. Method according to one of Claims 1 to 6, characterized in that, in the case of an active state of the row address signal (RAS), of the column address signals (CAS1, CAS2) and of the read signal (OE), the transition of the write signal (WE) into the active state is inhibited.

8. Method according to one of Claims 1 to 7, characterized in that the logic zero corresponds to the active states and the logic one corresponds to the passive states.

## Revendications

1. Méthode de lecture et de rafraîchissement (régénération) des contenus en données d'une mémoire dynamique à semi-conducteur avec une pluralité de cellules de mémoire volatiles disposées en forme de matrice sur des colonnes et des lignes, la lecture des contenus en données se faisant à partir de cellules de mémoire adressées au moyen d'au moins deux bus de données (DQ1, DQ2), sur lesquels les contenus en données sont appliqués mot par mot, et le rafraîchissement des contenus en données des cellules de mémoire se faisant grâce à une impulsion de rafraîchissement ou refresh
caractérisée par le fait que
les mots de données (D1, D3) appliqués, après déclenchement de l'impulsion de rafraîchissement, sur les bus de données (DQ1, DQ2) sont, pour un laps de temps prédéterminé, maintenus sur tous les bus de données et ne sont déconnectés qu'après ce laps de temps au moyen d'une impulsion de déconnexion.

2. Méthode selon la revendication 1 caractérisée par le fait que, grâce à un passage (1) d'un signal d'adresse de ligne (RAS) dans son état actif, une adresse de ligne (R) est affectée à une adresse appliquée sur un bus d'adresses (Adr), grâce à un passage (3, 5, 7) d'un signal d'adresse de colonne (CAS1, CAS2) dans son état actif, une adresse de colonne (C1, C2, C3) est affectée à une adresse appliquée au bus d'adresses (Adr), un état passif (8) de brève durée (t_{RF}) du signal d'adresse de ligne (RAS), pendant un état passif simultané d'au moins un signal d'adresse de colonne (CAS1, CAS2), correspond au signal de rafraîchissement et, grâce au passage (10) du signal d'adresse de ligne (RAS) dans son état passif, pendant un état passif simultané des deux signaux d'adresse de colonne (CAS1, CAS2), tous les mots de données appliqués aux bus de données (DQ1, DQ2) sont déconnectés.

3. Méthode selon l'une des revendications 1 à 2 caractérisée par le fait que, après un passage (1) du signal d'adresse de ligne (RAS), un passage (2) d'un signal de lecture (OE) et un passage (3) du signal d'adresse de colonne (CAS1, CAS2) dans leur état actif, le mot de données (D1, D2, D3), déposé dans les cellules de mémoire adressées, est appliqué sur le bus de données (DQ1, DQ2) correspondant au signal d'adresse de colonne (CAS1, CAS2) dans son état actif.

4. Méthode selon l'une des revendications 1 à 3 caractérisée par le fait que, lors d'un état actif du signal d'adresse de ligne (RAS) et du signal de lecture (OE) et d'un état passif du signal d'adresse de colonne (CAS1, CAS2) et du signal d'écriture (WE), les mots de données (D1, D2, D3), appliqués aux bus de données (DQ1, DQ2) correspondant au signal d'adresse de colonne (CAS 1, CAS2) dans son état passif, sont maintenus.

5. Méthode selon l'une des revendications 1 à 4 caractérisée par le fait que, lors d'un état passif du signal d'adresse de ligne (RAS) et de tous les signaux d'adresse de colonne (CAS1, CAS2), un état tristate (11) est établi sur tous les bus de données (DQ1, DQ2).

6. Méthode selon l'une des revendications 1 à 5 caractérisée par le fait que, lors d'un état actif des signaux d'adresse de ligne (RAS) et des signaux d'adresse de colonne (CAS1, CAS2) et d'un état passif du signal d'écriture (WE), la mémoire à semi-conducteur est assignée dans un état de lecture par assignation du signal de lecture (OE) dans son état actif.

7. Méthode selon l'une des revendications 1 à 6 caractérisée par le fait que, lors d'un état actif des signaux d'adresse de ligne (RAS), des signaux d'adresse de colonne (CAS1, CAS2) et du signal de lecture (OE), le passage du signal d'écriture (WE) dans son état actif est bloqué.

8. Méthode selon l'une des revendications 1 à 7 caractérisée par le fait que le "zéro" logique correspond aux états actifs et le "un" logique correspond aux états passifs.
